# EUROPÄISCHE PATENTSCHRIFT

(11) **EP 0 652 694 B1**
(45) Veröffentlichungstag und Bekanntmachung des Hinweises auf die Patenterteilung: **13.08.1997**
(21) Anmeldenummer: 94117454.2
(22) Anmeldetag: 04.11.1994
(51) Int. Cl.: H05K 5/00, H05K 7/20

(54) **Steuergerät für ein Kraftfahrzeug**
Control apparatus for vehicle
Appareil de commande pour automobile

(30) Priorität: 05.11.1993 DE 4337866
(43) Veröffentlichungstag der Anmeldung: 10.05.1995
(73) Patentinhaber: SIEMENS AKTIENGESELLSCHAFT, 80333 München (DE)
(72) Erfinder: Romanowski, Hans-Jürgen, D-93170 Bernhardswald (DE); Beuther, Christian, D-93049 Regensburg (DE)

(56) Entgegenhaltungen:
- EP-A- 0 625 871
- DE-A- 4 222 838
- DE-A- 4 243 180
- US-A- 4 905 123

## Beschreibung

Die Erfindung betrifft ein Steuergerät für ein Kraftfahrzeug, gemäß Oberbegriff von Patentanspruch 1.

Bei einem bekannten Steuergerät (DE 42 22 838 A1) sind Leistungsbauelemente auf einer Metallschicht, und zwar der Kupferkaschierung einer Leiterplatte angeordnet. Die Metallschicht transportiert die von den Leistungsbauelementen erzeugte Wärme zu einem Kühlkörper, der in thermischem Kontakt zu der Metallschicht steht.

Mit einem solchen Steuergerät kann aber nur eine begrenzte Wärmemenge über die Metallschicht nach außen abgeführt werden, da diese nur sehr dünn ist.

Ein anderes, bekanntes Steuergerät (DE 42 15 041) weist Leistungsbauelemente auf, die direkt auf einem Kühlkörper befestigt sind, der seinerseits auf der Leiterplatte befestigt ist.

Bei einem solchen Steuergerät bereitet die automatisierte Montage der Leistungsbauelemente große Schwierigkeiten, da die Leistungsbauelemente zuerst auf den Kühlkörper montiert werden müssen und danach kann der Kühlkörper auf der Leiterplatte befestigt werden. Außerdem sind die Leistungsbauelemente nicht wie die anderen Bauelemente der Schaltung in einer Ebene angeordnet, so daß nicht alle Bauelemente zusammen in einem Arbeitsvorgang automatisiert bestückt werden können.

In der nachveröffentlichten älteren europäischen Anmeldung EP 0 652 694 A1 wird vorgeschlagen, Leistungsbauelemente auf einem als Kühlfläche dienenden stufenförmigen Absatz einer Gehäusewanne anzuordnen. Eine eine elektronische Schaltung tragende Leiterplatte fluchtet mit der Kühlfläche.

Anschlußstifte der Leistungsbauelemente sind durch die Leiterplatte geführt und auf deren Rückseite verlötet.

Das Problem der Erfindung ist es, ein Steuergerät zu schaffen, das möglichst einfach montiert werden kann und bei dem die durch die Leistungsbauelemente erzeugte Wärme wirkungsvoll abgeführt werden kann.

Dieses Problem wird erfindungsgemäß durch die Merkmale des Patentanspruchs 1 gelöst. Dabei sind SMD-Bauelemente auf Kühlflächen einer Wärmesenke befestigt, die randseitig so mit der Leiterplatte verbunden ist, daß die Kühlflächen mit der Oberseite der Leiterplatte in etwa fluchten. Die Leistungsbauelemente sind also nicht auf der Leiterplatte angeordnet. Die Leiterplatte und die Wärmesenke sind thermisch entkoppelt. Dies hat den Vorteil, daß die Leistungsbauelemente nicht die Funktion der Schaltung infolge thermischer Belastung stören.

Vorteilhafte Ausgestaltungen der Erfindung sind in den Unteransprüchen gekennzeichnet. Dabei können die Kühlflächen ein Teil des Gehäuses sein, wobei die Leiterplatte und das Gehäuse miteinander verbunden sind. Die Kühlflächen können auch als eigene Kühlkörper ausgebildet sein, die auf verschiedenste Weise an der Leiterplatte befestigt sind. Besonders vorteilhaft ist es, die Wärmekapazität der Wärmesenke dadurch zu erhöhen, daß das Gehäuse als zusätzlicher Kühlkörper verwendet wird. Hierzu klemmen Gehäuseteile die Wärmesenke zwischen sich ein und führen somit die Wärme nach außen ab.

Ausführungsbeispiele der Erfindung sind im folgenden unter Bezugnahme auf die schematische Zeichnung näher erläutert. Es zeigen:
- Figur 1:: eine Draufsicht auf eine Leiterplatte eines erfindungsgemäßen Steuergeräts, an der ein Kühlkörper festigt ist,
- Figur 2:: einen Schnitt durch das Steuergerät entlang der Linie II-II gemäß Figur 1,
- Figur 3:: eine Draufsicht auf eine Leiterplatte eines weiteren Steuergeräts,
- Figur 4:: einen Schnitt durch das Steuergerät entlang der Linie A-A gemäß Figur 3 bei Verwendung einer Leiterplatte in dem Steuergerät, und
- Figur 5:: einen Schnitt durch das Steuergerät entlang der Linie A-A gemäß Figur 3 bei Verwendung von zwei Leiterplatten in dem Steuergerät.

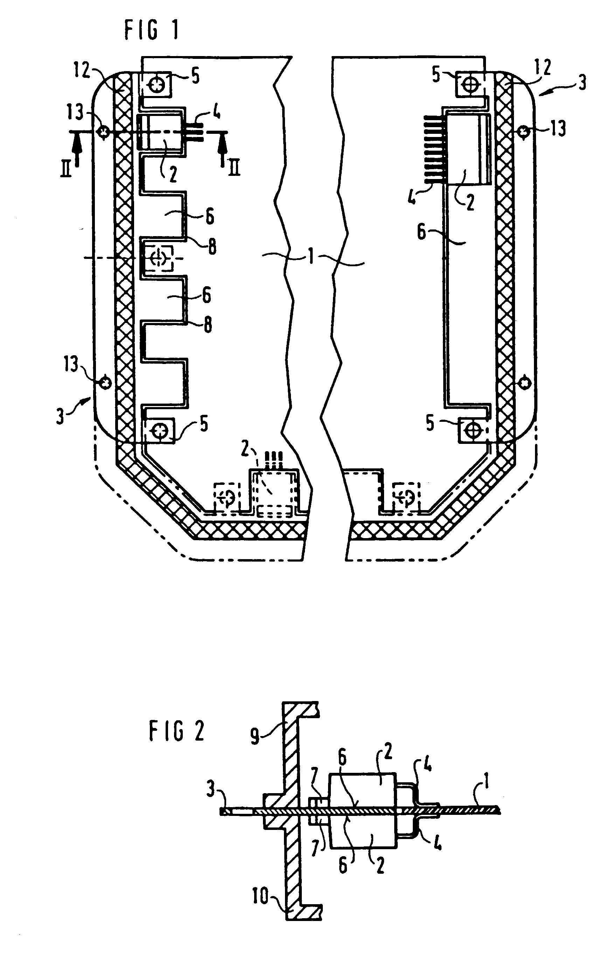

Ein elektronisches Steuergerät für ein Kraftfahrzeug, beispielsweise ein Motorsteuergerät, weist ein Gehäuse auf, in dem eine eine Schaltung tragende Leiterplatte 1 (Figur 1) angeordnet ist. Die Leiterplatte 1 ist mit nicht dargestellten SMD-Bauelementen (Surface Mounted Device) bestückt. Stark wärmeerzeugende Bauelemente (Leistungsbauelemente 2) werden auf einer Wärmesenke, z.B. einem Kühlkörper 3, befestigt und über ihre Anschlußbeine 4 mit der Leiterplatte 1 elektrisch verbunden.

Der Kühlkörper 3 ist in unmittelbarer Umgebung der Leiterplatte 1 angeordnet und an dieser befestigt, beispielsweise mit Hilfe von Befestigungslaschen 5 an die Leiterplatte 1 geschraubt oder genietet. Der Kühlkörper 3 kann durch Löten, Kleben oder steckbar mit der Leiterplatte 1 verbunden sein. Für die Erfindung ist es unwesentlich, wie der Kühlkörper 3 an der Leiterplatte 1 befestigt ist. Wesentlich ist, daß der Kühlkörper 3 thermisch von der Leiterplatte 1 entkoppelt ist, damit die Schaltung nicht thermisch belastet wird.

Der Kühlkörper 3 weist Kühlflächen 6 auf, die Teil der Kühlkörper 3 sind und auf denen die Leistungsbauelemente 2 angeordnet sind. Dabei liegen Kühlfahnen 5 der Leistungsbauelemente 2 auf den Kühlflächen 6 auf und sind somit in thermischem Kontakt mit den Kühlflächen 6. Dies kann dadurch geschehen, daß die Leistungsbauelemente 2 an der Kühlfläche 6 durch Schrauben, Nieten, Kleben, Löten oder durch Andrücken mit Hilfe eines elastischen Elements befestigt sind.

Die Kühlflächen 6 befinden sich in unmittelbarer Umgebung der Leiterplatte 1. Sie können sogar direkt an die Ränder der Leiterplatte 1 anstoßen. Die Kühlflächen 6 sind plattenförmig ausgebildet und haben eine Dicke, die in etwa derjenigen der Leiterplatte 1 entspricht (vgl. Figur 2).

Damit die Leistungsbauelemente 2 ebenso wie die anderen SMD-Bauelemente der Schaltung zur Montage automatisiert bestückt werden können, sind die Kühlfächen 6 und die Bauelementeseite der Leiterplatte 1, d.h. die Seite der Leiterplatte, auf denen die Bauelemente angeordnet sind, in einer Ebene angeordnet. Zumindest fluchten die Kühlflächen 6 in etwa mit der Oberseite der Leiterplatte 1. Wenn die Leiterplatte 1 zweiseitig mit Bauelementen bestückt wird, so ist es vorteilhaft, wenn auch die Unterseiten der Kühlfläche 6 und der Leiterplatte 1 miteinander fluchten. Somit können die Leistungsbauelemente 2 in den gleichen Ebenen montiert werden wie anderen Bauelemente der Schaltung.

Der Rand der Leiterplatte 1 kann, wie in Figur 1 dargestellt, Einbuchtungen 8 aufweisen, in denen die Kühlflächen 6 mit den Leistungsbauelementen 2 angeordnet sind. Somit können die elektrischen Verbindungswege zwischen der Schaltung auf der Leiterplatte 1 und den Leistungsbauelementen 2 verkürzt werden.

Damit die durch die Leistungsbauelemente 2 erzeugte Wärme besser nach außen abgeführt werden kann, ist es vorteilhaft, die Kühlflächen 6 zwischen ein Gehäuseober- und ein Gehäuseunterteil (im folgenden als Deckel 9 und Boden 10 bezeichnet) einzuklemmen (Figur 2). Die Auflagefläche des Deckels 9 und des Bodens 10 auf den Kühlflächen 6 ist in der Figur 1 durch die rautierte Fläche 12 dargestellt. Statt Deckel 9 und Boden 10 kann auch ein weiterer, nicht dargestellter Kühlkörper, der in ähnlicher Weise angeordnet ist wie Deckel und Boden, die Wärme nach außen abführen.

Der Kühlkörper 3 kann zusätzlich aus dem Gehäuse herausragen. Mit Hilfe von Bohrungen 13 in dem überstehenden Teil kann das Steuergerät beispielsweise im Motorraum an einer nicht dargestellten Wärmesenke befestigt werden.

Die Anzahl und Größe der Kühlkörper 3 hängt einerseits von ihrer Wärmekapazität und andrerseits von der Anzahl der Leistungsbauelemente 2 der Schaltung ab, die zu kühlen sind. In der Figur 1 sind hierzu zwei Möglichkeiten der Ausgestaltung der Kühlkörper 3 dargestellt. Es können z.B. zwei Kühlkörper (durchgezogenen Linien) an gegenüberliegenden Seiten der Leiterplatte 1 oder auch nur ein einziger Kühlkörper (strichpunktierte Linien) am Rande der Leiterplatte 1 angeordnet sein. Der oder die Kühlkörper 3 können die Leiterplatte 1 vollständig an ihrem Rand umgeben oder auch nur teilweise, beispielsweise auf einer einzigen Randseite der Leiterplatte 1.

An nicht mit Kühlkörpern 3 versehene Ränder der Leiterplatte 1 können - nicht in der Figur 1 dargestellte - Steckverbinder angeordnet sein, die mit der Leiterplatte 1 elektrisch verbunden sind.

Mit der erfindungsgemäßen Ausgestaltung des Steuergeräts können alle Bauelemente der Schaltung in einer Ebene automatisiert bestückt werden, falls der Kühlkörper 3 bereits vor dem Bestücken an der Leiterplatte 1 befestigt ist.

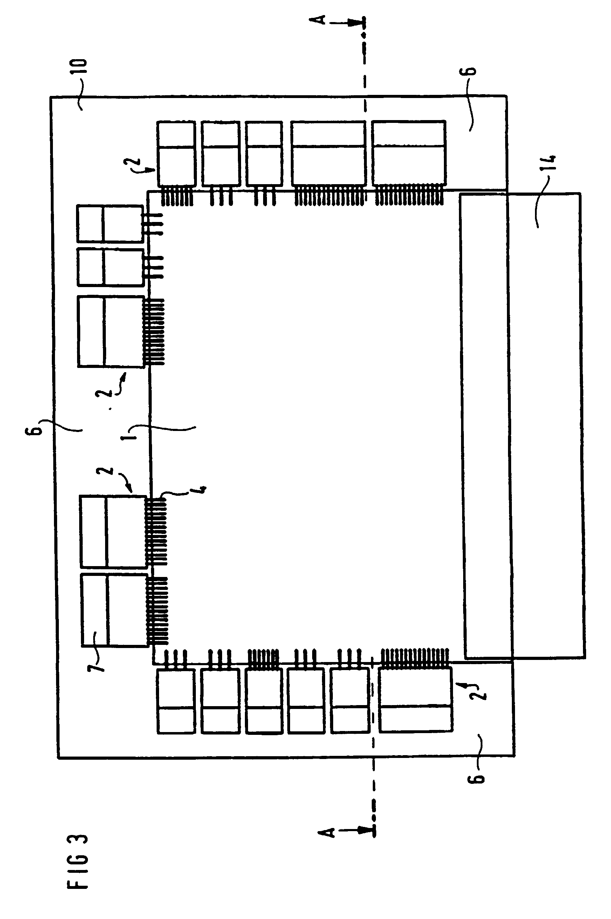

Bei weiteren Ausführungsbeispielen (Figuren 3 bis 5) bildet die Kühlfläche 6 einen Teil des Gehäuses. In diesen Figuren tragen Elemente gleicher Konstruktion oder Funktion dieselben Bezugszeichen wie in den Figuren 1 und 2.

Die Leistungsbauelemente 2 sind an drei Seiten der Leiterplatte 1 mit ihren Kühlfahnen 7 auf den Kühlflächen 6 befestigt (Figur 3). An der vierten Seite befindet sich ein Steckerteil 14, das mit der Leiterplatte 1 verbunden ist.

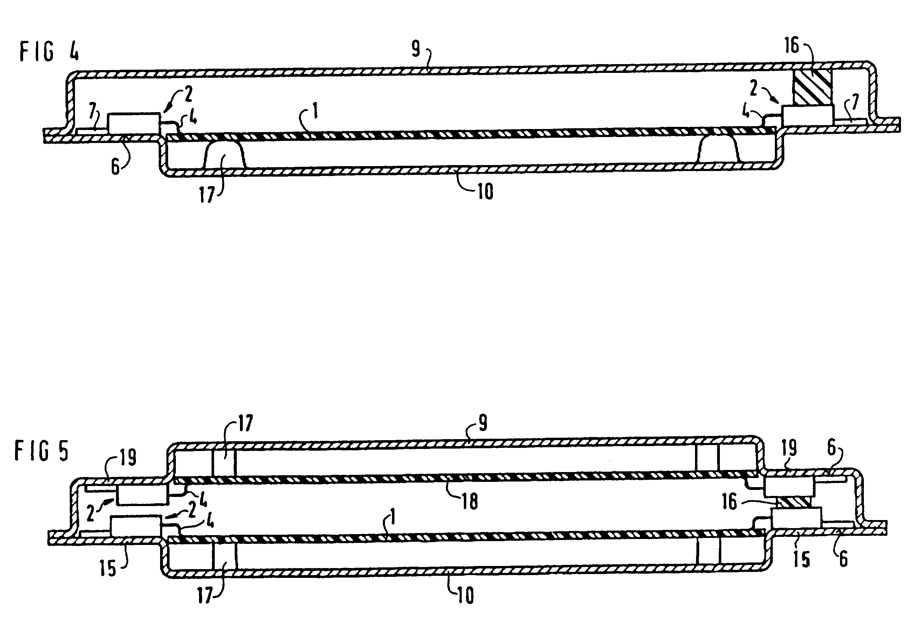

Der Deckel 9 und der Boden 10 bilden das Gehäuse (Figur 4), indem sie an ihren Rändern, beispielsweise mittels Schrauben, zusammengefügt werden. Der Deckel 9 und der Boden 10 sind aus einem gut wärmeleitenden Material, beispielsweise Aluminium, hergestellt. Der Boden 10 ist wannenförmig ausgebildet und weist einen abgewinkelten Rand 15 auf, auf dem die Leistungsbauelemente 2 befestigt sind. Der Boden 10 dient als Kühlkörper für die Leistungsbauelemente 2.

Für die Erfindung ist es unwesentlich, wie die Leistungsbauelemente 2 befestigt sind. Vorteilhaft ist es das Leistungsbauelement 2 auf die Kühlfläche 6 zu löten. Dies kann dann in einem Arbeitsvorgang zusammen mit dem Löten der übrigen Bauelementen der Leiterplatte 1 geschehen.

In Figur 4 werden die Leistungsbauelemente 2 mit Hilfe eines elastischen Elements 16, das auf den Leistungsbauelementen 2 aufsitzt, auf den Rand 15 gedrückt. Bei geschlossenem Gehäuse ist das elastische Element 16 vorgespannt und übt eine erforderliche Anpreßkraft auf die Leistungsbauelemente 2 aus, so daß diese gegen die Kühlfläche 6 gepreßt werden. Somit dient das Gehäuse als Kühlkörper.

Damit die Oberseite des Rands 15, d.h. die Kühlfläche 6, mit derjenigen der Leiterplatte 1 fluchtet, sind entsprechende große Abstandshalter 17 zwischen dem Boden und der Leiterplatte 1 angeordnet. Die Leiterplatte 1 ist an dem Boden 10 befestigt. Somit können alle Bauelemente der Schaltung in einer Ebene und in einem Arbeitsvorgang bestückt werden.

In Figur 5 ist ein Ausführungsbeispiel eines Steuergeräts dargestellt, bei dem zwei Leiterplatten 1 und 18 innerhalb des Gehäuses angeordnet sind. Sowohl der Deckel 9 als auch der Boden 10 sind wannenförmig mit einem abgewinkelten Rand 15 und 19 ausgebildet. Die Leiterplatten 1 und 18 sind mit Hilfe von Abstandshalter 17 so in dem Boden 10 bzw. in dem Deckel 10 befestigt, daß die Oberseite der Ränder 15 und 19 jeweils mit den Bauelementeseiten der Leiterplatten 1 und 18 fluchten. Die Ränder 15 und 19 dienen als Kühlfläche 6, auf denen die Leistungsbauelemente 2 befestigt sind.

Die Leistungsbauelemente 2 sind über ihre Anschlußbeine 4, die mit der Leiterplatte 1 verlötet sind, elektrisch mit dieser verbunden. Die Leistungsbauelemente 2 sind als SMD-Bauelemente ausgebildet sein. Dann sind ihre Anschlußbeine auf der Oberseite der Leiterplatte 1 aufgelötet. Die Anschlußbeine können auch durch die Leiterplatte 1 in Durchkontaktierungen gesteckt und gelötet werden.

Da die Leistungsbauelemente 2 direkt auf dem Gehäuse befestigt sind, wird die Wärme direkt, d.h. ohne Zwischenglieder und ohne verlustbehaftete Wärmeübergänge, nach außen abgeführt.

Somit können die Leistungsbauelemente 2 einfach und automatisiert zusammen mit den anderen Bauelementen der Schaltung in einer Ebene bestückt werden. Die Wärme der Leistungsbauelemente 2 wird wirkungsvoll abgeführt und die Schaltung wird nicht thermisch belastet.

## Patentansprüche

1. Steuergerät für ein Kraftfahrzeug, mit einem Gehäuse (9, 10), in dem eine eine elektronische Schaltung tragende Leiterplatte (1,18) angeordnet ist, mit einer Wärmesenke (3) mit einer Kühlfläche (6), wobei auf der Kühlfläche (6) wärmeerzeugende und mit der Schaltung verbundene Bauelemente (2) befestigt sind und die Kühlfläche (6) mit der Oberseite oder der Unterseite der Leiterplatte (1,18) in etwa fluchtet, **dadurch gekennzeichnet**, daß die Leiterplatte (1,18) und die Wärmesenke (3) thermisch entkoppelt sind, daß die Wärmesenke (3) randseitig der Leiterplatte (1,18) angeordnet ist, und daß die wärmeerzeugenden Bauelemente (2) als SMD-Bauelemente ausgebildet sind.

2. Steuergerät nach Anspruch 1, **dadurch gekennzeichnet**, daß die Wärmesenke (3) ein Teil des Gehäuses (9, 10) ist.

3. Steuergerät nach Anspruch 1, **dadurch gekennzeichnet**, daß die Wärmesenke (3) an der Leiterplatte (1, 18) mit Schrauben oder Nieten befestigt ist.

4. Steuergerät nach Anspruch 1, **dadurch gekennzeichnet**, daß die Wärmesenke (3) an der Leiterplatte (1, 18) angelötet ist.

5. Steuergerät nach Anspruch 1, **dadurch gekennzeichnet**, daß die Wärmesenke (3) an der Leiterplatte (1, 18) steckbar befestigt ist.

6. Steuergerät nach Anspruch 1, **dadurch gekennzeichnet**, daß das Gehäuse ein Gehäuseoberteil (9) und ein Gehäuseunterteil (10) aufweist, die auf den Kühlflächen (6) aufliegen und die Wärmesenke (3) zwischen sich einklemmen.

## Claims

1. Control unit for a motor vehicle, having a housing (9, 10) in which a printed circuit board (1, 18) carrying an electronic circuit is arranged, having a heat sink (3) with a cooling surface (6), heat-generating components (2) connected to the circuit being fastened to the cooling surface (6), and the cooling surface (6) being approximately flush with the top side or the bottom side of the printed circuit board (1, 18), characterized in that the printed circuit board (1, 18) and the heat sink (3) are thermally decoupled, in that the heat sink (3) is arranged at the edge of the printed circuit board (1, 18), and in that the heat-generating components (2) are constructed as SMD components.

2. Control unit according to Claim 1, characterized in that the heat sink (3) is a part of the housing (9, 10).

3. Control unit according to Claim 1, characterized in that the heat sink (3) is fastened to the printed circuit board (1, 18) with screws or rivets.

4. Control unit according to Claim 1, characterized in that the heat sink (3) is soldered to the printed circuit board (1, 18).

5. Control unit according to Claim 1, characterized in that the heat sink (3) is pluggably fastened to the printed circuit board (1, 18).

6. Control unit according to Claim 1, characterized in that the housing has a housing upper part (9) and a housing lower part (10) which bear against the cooling surfaces (6) and clamp the heat sink (3) between them.

## Revendications

1. Appareil de commande pour un véhicule automobile, comportant un boîtier (9, 10) dans lequel est disposée une plaque imprimée portant un circuit électronique (1, 18), comportant un puits de chaleur (3) avec une surface de refroidissement (6), des composants (2), qui sont reliés au circuit et qui produisent de la chaleur, étant fixés sur la surface de refroidissement (6), et la surface de refroidissement (6) étant sensiblement dans l'alignement de la face supérieure ou de la face inférieure de la plaque imprimée (1, 18),
caractérisé en ce que la plaque imprimée (1, 18) et le puits de chaleur (3) sont découplés thermiquement, en ce que le puits de chaleur (3) est disposé au voisinage extérieur de la périphérie de la plaque imprimée (1, 18) et en ce que les composants (2) produisant de la chaleur sont réalisés sous la forme de composants SMD (Surface Mounted Device).

2. Appareil de commande suivant la revendication 1, caractérisé en ce que le puits de chaleur (3) est une partie du boîtier (9, 10).

3. Appareil de commande suivant la revendication 1, caractérisé en ce que le puits de chaleur (3) est fixé sur la plaque imprimée (1, 18) par des vis ou des rivets.

4. Appareil de commande suivant la revendication 1, caractérisé en ce que le puits de chaleur (3) est soudé sur la plaque imprimée (1, 18).

5. Appareil de commande suivant la revendication 1, caractérisé en ce que le puits de chaleur (3) est fixé par enfichage sur la plaque imprimée (1, 18).

6. Appareil de commande suivant la revendication 1, caractérisé en ce que le boîtier présente une partie supérieure de boîtier (9) et une partie inférieure de boîtier (10) , qui reposent sur les surfaces de refroidissement (6) et pincent entre elles le puits de chaleur (3).
